(19) Europäisches Patentamt
European Patent Office
Office européen des brevets

(11) Veröffentlichungsnummer: **0 177 905**
**B1**

(12) **EUROPÄISCHE PATENTSCHRIFT**

(45) Veröffentlichungstag der Patentschrift: **05.12.90**

(51) Int. Cl.$^5$: **G 03 F 7/26**

(21) Anmeldenummer: **85112572.4**

(22) Anmeldetag: **04.10.85**

(54) **Verfahren zum Entwickeln und zum Entschichten von Photoresistschichten mit quaternären Ammomiumverbindungen.**

(30) Priorität: **20.06.85 JP 135030/85**
**09.10.84 JP 211742/84**
**12.02.85 JP 24975/85**
**12.02.85 JP 24976/85**

(43) Veröffentlichungstag der Anmeldung:
**16.04.86 Patentblatt 86/16**

(45) Bekanntmachung des Hinweises auf die Patenterteilung:
**05.12.90 Patentblatt 90/49**

(84) Benannte Vertragsstaaten:
**AT CH DE FR GB IT LI NL SE**

(56) Entgegenhaltungen:
**EP-A-0 062 733**
**EP-A-0 097 282**
**EP-A-0 124 297**
**FR-A- 819 000**
**GB-A-1 060 256**
**GB-A-1 147 647**
**US-A-2 185 163**

**EXTENDED ABSTRACTS, band 76-2, 17.-22. Oktober 1976, Seite 911, Zusammenfassung Nr. 354, Las Vegas, Nevada, US; M. ASANO et al.: "Application of choline in semiconductor technology"**

(73) Patentinhaber: **HOECHST JAPAN KABUSHIKI KAISHA**
**New Hoechst Building No. 10-16, 8-chome**
**Akasaka Minato-ku Tokyo (JP)**

(73) Patentinhaber: **NISSO PETROCHEMICAL INDUSTRIES CO., Ltd.**
**4-1 Nihonbashi Hon-cho**
**Chuo-ku Tokyo (JP)**

(72) Erfinder: **Itoh, Kunio**
**1429-404, Hatsuzawa-cho**
**Hachioji-shi Tokyo (JP)**
Erfinder: **Watabe, Kimio**
**378-3 Tarusaka-cho**
**Yokkaichi-shi Mie-ken (JP)**
Erfinder: **Shiozaki, Masahiro**
**2326-10, Iijima-cho Totsuka-ku**
**Yokohama-shi Kanagawa-ken (JP)**

(74) Vertreter: **Meyer-Dulheuer, Karl-Hermann, Dr. et al**
**HOECHST Aktiengesellschaft Werk Kalle-Albert**
**Zentrale Patentabteilung KA Rheingaustrasse**
**190 Postfach 3540**
**D-6200 Wiesbaden 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Courier Press, Leamington Spa, England.

**Beschreibung**

Die Erfindung betrifft ein Verfahren zur Behandlung von Photoresistschichten mit einer Lösung von quaternären Ammoniumverbindungen in Wasser und bzw. oder einem mit Wasser mischbaren oranischen Lösungsmittel, die zum Entwickeln und ggf. zum Entschichten von Photoresistschichten geeignet ist, ein Verfahren zum Entwickeln von belichteten Photoreistschichten und ein Verfahren zum Entschichten von Photoresistschablonen.

Photoresistschichten, insbesondere positiv arbeitende Schichten, z.B. auf Basis von 1,2-Naphthochinondiaziden und Novolaken oder Polyvinylphenolen, werden im allgemeinen mit wäßrigen oder Wasser enthaltenden Lösungen von Basen entwickelt. Dabei werden die belichteten Schichtbereiche gelöst und ausgewaschen. Die üblicherweise verwendeten anorganischen Alkalien haben den Nachteil, daß sie die als Schichtträger dienenden Wafer aus Silicium durch Eindiffundieren von Metallionen verunreinigen. Um diesen Nachteil zu beseitigen, wurden konzentrierte wäßrige Lösungen von Tetramethylammoniumhydroxid oder Cholin eingesetzt. Die Verwendung derartiger Lösungen zum Entwickeln oder Entschichten von Photoresistschichten ist z.B. in der JP—A 35 424/81 beschrieben.

Diese Lösungen sind aber gewöhnlich so aggresiv, daß sie beim Entwickeln nicht nur die Nichtbildstellen, sondern auch die Bildstellen der Photoresistschicht, angreifen. Wenn man die Lösungen so weit verdünnt, daß beim Entwickeln nur die Nichtbildstellen gelöst werden bzw. daß beim Entschichten nur die Photoresistschablone entfernt und das Trägermaterial nicht angegriffen wird, wird die Zeit bis zur vollständigen Entfernung der aufzulösenden Bereiche zu sehr verlängert.

In der GB—A 1 147 647 wird die Herstellung von Mono-(hydroxyalkyl)ammoniumbasen beschrieb en. Eine Verwendung dieser Verbindungen als Entwickler ist nicht beschrieben.

Ebenso beschreibt die nicht vorveröffentlichte, aber prioritätsältere EP—A 0 124 297 quaternäre Ammoniumhydroxide, die bis zu vier Hydroxyalkylgruppen als organische Reste aufweisen können, die in Entwicklern für positiv arbeitende Photoresists verwendet werden können.

Die US—A 2 185 163 offenbart quaternäre Ammoniumhydroxide, in denen ein organischer Rest eine Hydroxyalkyloxyalkylgruppe darstellt, und deren Herstellung. Die Verwendung derartiger Verbindungen wird nicht beschrieben.

Aufgabe der Erfindung war es, ein Verfahren zur Behandlung von Photoresistschichten vorzuschlagen, wobei die Entwicklerlösung keine Metallionen enthält, die innerhalb kurzer Zeiten die Nichtbildstellen der Photoresistschicht bzw. die Photoresistschablone entfernt, ohne die Bildstellen bzw. den Schichtträger anzugreifen.

Erfindungsgemäß wird ein Verfahren zur Behandlung von Photoresistschichten mit einer Lösung vorgeschlagen, die

a) eine Verbindung der Formel I

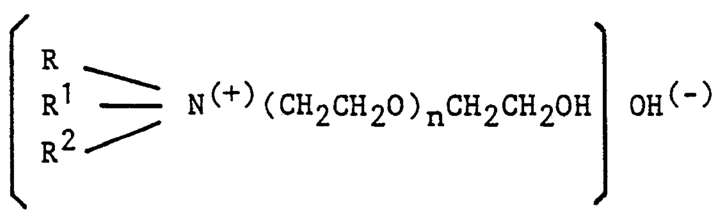

(I)

worin

R, $R^1$ und $R^2$ gleiche oder verschiedene Alkylgruppen mit 1 bis 5 Kohlenstoffatomen sind und

n eine Zahl von 1 bis 10 ist,

und

b) Wasser oder ein mit Wasser mischbares organisches Lösemittel oder eikn Gemisch von beidem enthält.

Erfindungsgemäß wird weiterhin ein Verfahren zum Entwickeln einer belichteten lichtempfindlichen Photoresistschicht vorgeschlagen, bei dem die Nichtbildstellen der Photoresistschicht mit einer Lösung einer quaternären Ammoniumbase ausgewaschen werden, dadurch gekennzeichnet, daß die Ammoniumbase eine Verbindung der Formel I

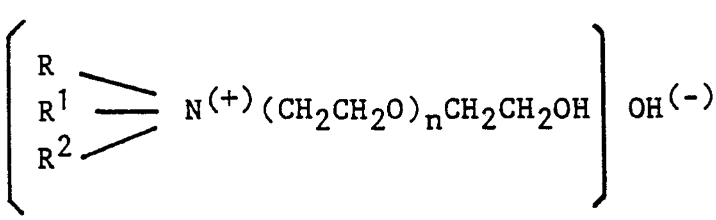

(I)

ist, worin

R, $R^1$ und $R^2$ gleiche oder verschiedene Alkylgruppen mit 1 bis 5 Kohlenstoffatomen sind und

n eine Zahl von 1 bis 10 ist.

Erfindungsgemäß wird schießlich auch ein Verfahren zum Entschichten von Photoresistschablonen vorgeschlagen. Dieses Verfahren ist dadurch gekennzeichnet, daß man die Schablone durch Behandeln mit einer Lösung einer Verbindung der Formel I

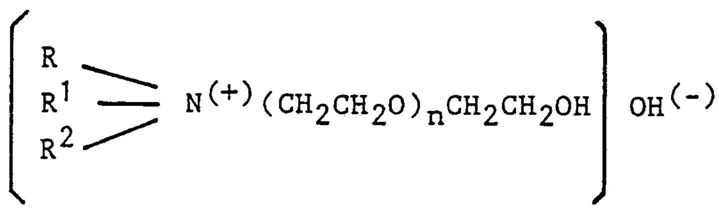

(I)

entschichtet, worin

R, $R^1$ und $R^2$ gleiche oder verschiedene Alkylgruppen mit 1 bis 5 Kohlenstoffatomen sind und

n eine Zahl von 1 bis 10 ist.

Die Herstellung der Verbindungen gemäß der allgemeinen Formel I ist auf verschiedene Weise möglich. Wenn in Formel I $n = 1$ is, wird ein Trialkylamin mit 2-(2-Chlorethoxy)ethanol oder N,N-Dialkylaminoethoxyethanol mit einem Alkylhalogenid in einem geeigneten Lösemittel zum Trialkyl-2-(2-hydroxy-ethoxy)ethylamoniumhalogenid umgesetzt und das Halogenidion in geeigneter Weise, z.B. mit einem OH-Ionenaustauscher, unter Bildung einer Verbindung der Formel I durch das OH-Ion ersetzt. Wenn ein Gemisch von Verbindungen der Formel I hergestellt werden soll, in dem n einen mittleren Wert zwischen 1 und 10 hat, wird 1 Äquivalent Trialkylamin und mindestens ein Äquivalent Wasser in einem geeigneten Lösemittel mti mindestens zwei Äquivalenten Ethylenoxid umgesetzt.

Die Reste R, $R^1$ und $R^2$ in der allgemeinen Formel I sind bevorzugt Alkylgruppen mit 1 bis 3 Kohlenstoffatomen, z.B. Methyl-, Ethyl-, Propyl- oder Isopropylgruppen. Besonders bevorzugt sind alle Reste R, $R^1$ und $R^2$ Methylgruppen. Wenn die Anzahl der Kohlenstoffatome in jeder Alkylgruppe höher als 5 ist, wird das Äquivalentgewicht der Base zu hoch, so daß die Gewichtskonzentration der Lösung zu hoch angesetzt werden muß.

In der Formel I bedeutet n die mittlere Zahl der wiederkehrenden Oxyalkyleneinheiten im Molekül: Wenn n im Mittel kleiner als 1 oder größer als 10 ist, ist die Verbindung der Formel I als basischer Bestandteil der erfindungsgemäßen Verarbeitungslösung weniger geeignet. Die Verbindung der Formel I kann entweder als einzelne Verbindung oder als Homologengemisch vorliegen. Die erfindugsgemäße Verarbeitungslösung kann demnach eine oder mehrere der Verbindungen der Formel I enthalten.

Das mit Wasser mischbare organische Lösemittel kann z.B. ein aliphatischer Alkohol mit 1 bis 4 Kohlenstoffatomen, Aceton, Butanon, N-Methyl-pyrrolidon, Dimethylsulfoxid, Dimethylformamid oder Dimethylacetamid sein. Die bevorzugten organischen Lösemittel sind aliphatische Alkohole, Aceton und N-Methylpyrrolidon. Beispiele für geeignete Alkohole sind Methanol, Ethanol, Isopropanol und sek.-Butanol.

Die Verbindungen der Formel I sind beständig in Wasser und bzw. oder dem mit Wasser mischbaren organischen Lösemittel.

Wenn Wasser oder ein aliphatischer Alkohol mit 1 bis 4 Kohlenstoffatomen als Lösemittel bei der Herstellung der Verbindung der Formel I eingesetzt wird, kann die erhaltene Reaktionslösung unmittelbar als Photoresistverarbeitungslösung eingesetzt werden. Die Verbindung kann aber auch zunächst in einem anderen Lösemittel hergestellt werden, wonach dieses Lösemittel abdestilliert und nach und nach durch ein anderes geeignetes Lösemittel für die Verarbeitungslösung ersetzt wird. Wasser oder mit Wasser mischbare organische Lösemittel können allein als Lösemittel für die erfindungsgemäße Behandlungs- bzw. Verarbeitungslösung eingesetzt werden. Es können auch Gemische organischer Lösemittel untereinander oder mit Wasser Verwendung finden. Das Mengenverhältnis der Lösemittelkomponenten kann in jedem Fall nach Bedarf eingestellt werden.

Wenn die Verarbeitungslösung als Entschichter verwendet wird, werden Aceton oder N-Methylpyrrolidon als organische Lösemittel bevorzugt. Mit besonderem Vorteil werden diese Lösemittel im Gemisch mit Wasser eingesetzt. Auch zum Entwickeln von Positiv oder negativ arbeitenden Photoresists können diese bvevorzugten Lösungen mit Vorteil eingesetzt werden. Die Konzentration der Verbindung der Formel I in der Verarbeitungslösung liegt im allgemeinen zwischen 0,01 und 50, bevorzugt zwischen 0,05 und 30 Gew.-%.

Je nach den besonderen Erfordernissen des Enzelfalls, z.B. danach ob die Lösung als Entwickler oder als Entschichter eingesetzt wird oder danach, welche Art Resist verarbeitet werden soll, und nach den Bedingungen, wie Temperatur und Dauer der Behandlung, kann der Konzentrationsbereich gewählt werden.

Die folgenden Herstellungs- und Anwendungsbeispiele erläutern bevorzugte Ausführungsformen der Erfindung. Alle Teile, Prozentangaben und Mengenverhältnisse sind auf das Gewicht bezogen, wenn nichts anderes angegeben ist.

Herstellungsbeispiel 1

Herstellung von Trimethyl-hydroxyethoxyethylammoniumhydroxid

Ein Autoklav von 500 ml Fassungsvermögen wurde mit 200 Teilen Methanol und 72,8 Teilen Trimethylamin beschickt. Nach Erwärmen der Lösung auf 100°C wurden 125 Teile 2-(2-Chlor-ethoxy)ethanol im Verlauf einer Stunde zugesetzt, und das erhaltene Gemisch wurde weitere 4 Stunden unter Rühren auf 100°C erwärmt. Nachdem die Reaktion beendet war, wurde das Methanol im Vakuum aus dem Reaktionsgemisch abdestilliert. Der Rückstand wurde mit 200 Teilen Aceton versetzt, wobei das Trimethyl-hydroxyethoxyethyl-ammoniumchlorid kristallisierte. Das Produkt wurde abfiltriert und getrocknet, wonach 176 Teile (96% d. Th.) erhalten wurden.

80 Teile des erhaltenen Trimethyl-hydroxyethoxyethylammoniumchlorids wurden in reinem Wasser zu insgesamt 1000 Teilen Lösung aufgelöst. Diese Lösung wurde mit einer Geschwindigkeit von 2 Säulenvolumina je Stunde durch eine Säule laufen gelassen, die mit 700 ml eines zuvor regenerierten Anionenaustauschers in der OH-Ionenform (Dia-Ion SA-10A vonn Mitsubishi Chemical Industries Ltd.) mit einer Gesamtkapazität von 0,91 val beschickt war. Eine wäßrige Lösung, die 6,0 Gew.-% Trimethylhydroxyethoxyethyl-ammoniumhydroxid enthielt, wurde in einer Menge von 1170 Teilen erhalten.

Eine wäßrige Lösung von Natriumtetraphenylboranat wurde dem Eluat des Ionenaustauschers zugesetzt, wobei sich ein Niederschlag bildete. Es wird angenommen, daß dabei die folgende Umsetzung stattgefunden hat:

$$[(CH_3)_3NCH_2CH_2OCH_2CH_2OH]^{(+)}OH^{(-)} + [(C_6H_5)_4B]Na \rightarrow$$

$$[(CH_3)_3NCH_2CH_2OCH_2CH_2OH]^{(+)}[(C_6H_5)_4B]^{(-)} + NaOH$$

Zu einem weiteren Anteil des Eluats wurde Phosphorwolframsäure gegeben, und der erhaltene Niederschlag wurde zur quantitativen Bestimmung getrocknet. Danach wurde der Niederschlag bei etwa 800°C zersetzt, wobei Phosphorwolframsäureanhydrid gebildet wurde. Die Analyse ergab, daß das Trimethyl-hydroxyethoxyethyl-ammoniumhydroxid das Molekulargewicht 167.2 hatte. Die Fällungsreaktion verläuft, wie angenommen wird, nach dem folgenden Schema:

$$3\ [(CH_3)_3NCH_2CH_2OCH_2CH_2OH]^{(+)}OH^{(-)} + H_3PO_4 \cdot 12WO_3 \rightarrow$$

$$[(CH_3)_3NCH_2CH_2OCH_2CH_2OH]_3PO_4 \cdot 12WO_3 + 3H_2O$$

Herstellungsbeispiel 2

Ein Autoklav von 500 ml Fassungsvermögen wurde mit 200 Teilen Methanol und 94,5 Teilen Triethylamin beschickt. Nach Erwärmen der Lösung auf 130°C wurden 135 Teile 2-[2-(2-Chlor-ethoxy)ethoxy]ethanol innerhalb einer Stunde zugesetzt, und das erhaltene Gemisch wurde weitere 4 Stunden auf 130°C erwärmt. Der Rückstand wurde wie im Herstellungsbeispiel 1 zur Kristallisation gebracht, wobei 205 Teile Triethyl-2-[2-(2-hydroxy-ethoxy)ethoxy]ethylammoniumchlorid (Ausbeute 95%) erhalten wurden.

94,5 Teile dieses quaternären Ammoniumchlorids wurden in reinem Wasse zu einer Lösung von insgesamt 1000 Teilen aufgelöst. Die Lösung wurde mit der Geschwindigkeit von 2 Säulenvolumina je Stunde durch eine mit dem gleichen Ionenaustauscher wie im Herstellungsbeispiel 1 beschickte Säule laufen gelassen. Es wurden 1440 Teile einer Lösung erhalten, die 6,1% Triethyl-2-[2-(2-hydroxy-ethoxy)ethoxy]ethylammoniumhydroxid enthielt. Die Natur des gewünschten quaternären Ammoniumhydroxids und der Gehalt der Lösung wurden wie im Herstellungsbeispiel 1 bestimmt.

Herstellungsbeispiele 3 bis 6

Ein 500 ml fassender Autoklav wurde mit Wasser und Trimethylamin in den in Tabelle 1 angegebenen Mengen beschickt. In das Gemisch wurde 2 Stunden lang Ethylenoxid bei der in der Tabelle angegebenen Temperatur eingeleitet. Das erhaltene Gemisch wurde eine weitere Stunde bei der gleichen Temperatur gerührt. Danach wurde der Druck im Autoklaven auf 1 Atmosphäre herabgesetzt und das Gemisch mit Wasser auf einen Gehalt von etwa 15 Gew.% verdünnt. Die Ergebnisse sind in Tabelle I angegeben.

Jede der erhaltenen wäßrigen Lösungen wurde wie im Herstellungsbeispiel 1 angegeben analysiert.

Tabelle 1

| Reaktionsbedingungen | | | | | Ergebnisse | | | |
|---|---|---|---|---|---|---|---|---|
| Beispiel Nr. | Wasser Teile | $(CH_3)_3N$ Teile | Etylenoxid Teile | Temperatur °C | Menge des Reaktionsgemischs Teile | Menge des verdünnten Reaktionsgemischs Teile | Alkalikonzentration mval/g | Mittleres Molekulargewicht |
| 3 | 326 | 29,5 | 110 | 10 | 456 | 913 | 0,536 | 167 (1,0) * |
| 4 | 170 | 34,0 | 127 | 30 | 325 | 1000 | 0,564 | 217 (2,2) * |
| 5 | 170 | 34,0 | 127 | 10 | 324 | 1002 | 0,562 | 242 (2,7)* |
| 6 | 400 | 21,0 | 154 | 30 | 580 | 1100 | 0,210 | 183 (1,2)* |

* Die Zahlen in Klammern bedeuten n in der Formel I

Herstellungsbeispiel 7

80 Teile Trimethyl-hydroxyethoxyethyl-ammoniumchlorid, erhalten wie im Herstellungsbeispiel 1 beschrieben, wurden in 150 Teilen Ethanol gelöst. Zu der Lösung wurde eine 5%ige ethanolische Kalilauge in einer Menge gegeben, die der des Ammoniumchlorids äquivalent war, und der erhaltene Niederschlag wurde abfiltriert. Der Niederschlag bestand, wie gefunden wurde, aus Kaliumchlorid, und seine Menge betrug 31,9 Teile. Daraus ergab sich, daß 98% des Chlorids in Trimethyl-hydroxyethoxyethylammoniumhydroxid umgewandelt waren. Etwa 2000 Teile Wasser wurden zu der Hydroxidlösung gegeben, und es wurde so viel Ethanol wie möglich bei 40 mbar abdestilliert.

Anwendungsbeispiel 1

A) Siliciumwafer von etwa 10 cm Durchmesser, die in der <100>-Ebene geschnitten waren, wurden mit einer wäßrigen Lösung von $H_2O_2$ und Schwefelsäure leicht angeätzt und gründlich mit entsalztem Wasser gewaschen. Nachdem die Leitfähigkeit des ablaufenden Waschwassers weit genug abgesunken war, wurden die Wafer eine Stunde oder länger zur Entfernung des Wassers erhitzt. Dann wurden sie mit Hexamethyldisilazan bvehandelt und abgekühlt.

B) Die nach Stufe A erhaltenen reinen Si-Wafer wurden mit einer Lösung von

| | | |
|---|---|---|
| 6 | Gewichtsteilen | des 1,2-Napthochinon-2-diazid-5-sulfonsäureesters des 2,3,4-Trihydroxy-benzophenons und |
| 21 „ | „ | Novolak in |
| 60 „ | „ | 2-Ethoxy-ethylacetat, |
| 7 „ | „ | Xylol und |
| 7 „ | „ | Butylacetat |

schleuderbeschichtet. Die beschichteten Wafer wurden 5 Minuten auf 90°C vorerhitzt. Die Photoresistschicht auf den Wafern war danach etwa 2 µm dick. Die Wafer wurden dann unter einem Proximity-Kontaktkopierer der Canon Inc. belichtet. Als Lichtquelle diente eine Ultrahochdruck-Quecksilberdampflampe, die mit einem ND 50 Filter zur Dämpfung der Intensität der UV-Strahlung versehen war. Die Internsität der UV-Strahlung betrug 7,6 $mW/cm^2$ bei 400 nm.

C) Die Photoresistschicht von drei der bebilderten Wafer wurde mit den in den Herstellungsbeispielen 1, 3 und 4 erhaltenen Verarbeitungslösungen behandelt. Die Photoresistschicht auf dem anderen Wafer wurde mit einem handelsüblichen Cholinentwickler behandelt. Die Entwicklung erfolgte durch Tauchen, wobei das Entwicklungsbad nahe bei Raumtemperatur gehalten und gerührt wurde. Die Ergebnise zeigt Tabelle 2.

Die unter "Belichtungsenergie" in der Tabelle angegebenen Werte wurden wie folgt gemessen: Die einzelnen Wafer wurden unterschiedlich lange belichtet und dann eine bestimmte Zeitlang entwickelt. Danach wurde die Dicke der Photoresistschicht mit einem optischen Dickenmeßgerät interferometrisch bestimmt, wobei als Brechungsindex der Schicht n = 1,64 angenommen wurde. Durch Auswertung und Extrapolation wurde die Belichtungsdosis ermittelt, die für eine verbleibende Schichtdicke von 0% erforderlich war.

Tabelle 2

Wirkung der erfindungsgemäßen Lösungen als Photoresistentwickler

| Versuch Nr. | Verbindung | Lösemittel | Konzentration val/l | Entwicklungszeit (Minuten) | Belichtungsenergie ($mJ/cm^2$) |
|---|---|---|---|---|---|
| 1 | Herstellungsbeispiel 1 | Wasser | 0,2033 | 1,00 | 38,00 |
| 2 | Herstellungsbeispiel 3 | Wasser | 0,1650 | 1,00 | 34,96 |
| 3 | Herstellungsbeispiel 4 | Wasser | 0,1715 | 0,83 | 30,40 |
| 4 (Vergleichsversuch) | Cholin | Wasser | 0,3907 | 1,00 | 42,56 |

Die obigen Ergebnisse zeigen, daß die Verarbeitungslösungen, die die nach den Herstellungsbeispielen 1, 3 und 4 erhaltenen Verbindungen enthielten, bei gleicher Entwicklung geringere Belichtungsenergien erforderten als die Vergleichsprobe. Außerdem sind die erforderlichen Konzentrationen bei den Verbindungen nur etwa halb so hoch wie bei Cholin. Es ist deshalb leichter, die mit den erfindungsgemäßen Lösungen erhaltenen Abwässer zu entsorgen.

Anwendungsbeispiel 2

Eine wie im Anwendungsbeispiel 1 durch Belichten und Entwicklen auf Silicium-Wafern erhaltene Photoresistschablone wurde 10 Minuten auf 120°C nacherhitzt. Danach wurden die Wafer in verschiedene gerührte Behandlungslösungen bei Raumtemperatur getaucht. Die Ergebnisse der Entschichtung zeigt Tabelle 3.

Tabelle 3

Wirksamkeit der erfindungsgemäßen Lösungen als Entschichter für Photoresistschablonen

| Versuch Nr. | Verbindung | Lösemittel | Konzentration val/l | Behandlungszeit (Sekunden) | Entschichtung |
|---|---|---|---|---|---|
| 1 | Herstellungsbeispiel 1 | Wasser | 0,32 | $\leq 40$ | gut |
| 2 | Herstellungsbeispiel 3 | Wasser | 0,51 | $\leq 20$ | ausgezeichnet |
| 3 | Herstellungsbeispiel 3 | Wasser | 0,25 | $\leq 40$ | gut |
| 4 | Herstellungsbeispiel 3 | Ethanol | 0,25 | $\leq 40$ | gut |
| 5 | Herstellungsbeispiel 3 | Wasser/Aceton (1:1) | 0,17 | $\leq 40$ | gut |
| 6 | Herstellungsbeispiel 3 | Wasser/N-Methylpyrrolidon (1:2) | 0,20 | $\leq 40$ | gut |
| 7 (Vergleichsbeispiel) | Cholin | Wasser | 0,39 | $\geq 600$ | nicht entschichtet |

Die Werte in Tabelle 3 zeigen, daß die Verarbeitungslösungen als Entschichter für Photoresistschablonen auch bei niedrigeren Konzentrationen, als sie für Cholin erforderlich sind, eine sehr gute Wirkung zeigen. Wenn Cholin in gleicher Konzentration wie die erfindungsgemäßen Verbindungen eingesetzt wird, muß die Behandlungszeit verlängert werden, um eine ausreichende Entschichtung zu bewirken. Dies zeigt die ausgezeichnete Wirksamkeit, die mit den Verarbeitungslösungen erreicht wird.

**Patentansprüche**

1. Verfahren zur Behandlung von Photoresistschichten mit einer Lösung, enthaltend
a) eine Verbindung der Formel (I)

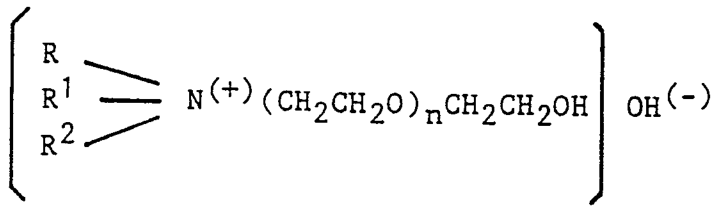

(I)

worin
R, $R^1$ und $R^2$ gleich oder verschiedene Alkylgruppen mit 1 bis 5 Kohlenstoffatomen sind und
n eine Zahl von 1 bis 10 ist,
und
b) Wasser oder ein mit Wasser mischbares organisches Lösemittel oder ein Gemisch von beidem.

2. Verfahren nach Anspruch 1, dadurch gekennzeichnet, daß die Lösung als Lösemittel nur Wasser enthält.

3. Verfahren nach Anspruch 1, dadurch gekennzeichnet, daß R, $R^1$ und $R^2$ Methylgruppen sind.

4. Verfahren nach Anspruch 1, dadurch gekennzeichnet, daß die Lösung 0,01 bis 50 Gew.-% der Verbindung der Formel (I) enthält.

5. Verfahren zum Entwickeln einer belichteten lichtempfindlichen Photoresistschicht, bei dem die Nichtbildstellen der Photoresistschicht mit einer Lösung einer quaternären Ammoniumbase ausgewaschen werden, dadurch gekennzeichnet, daß man als Ammoniumbase eine Verbindung der Formel (I) gemäß Anspruch 1 einsetzt.

6. Verfahren nach Anspruch 5, dadurch gekennzeichnet, daß die Verbindung der Formel (I) in Wasser oder in einem mit Wasser mischbaren Lösemittel oder einem Gemisch von beidem gelöst ist.

7. Verfahren nach Anspruch 6, dadurch gekennzeichnet, daß die Photoresistschicht positiv arbeitet und die belichteten Schichtbereiche ausgewaschen werden.

8. Verfahren nach Anspruch 7, dadurch gekennzeichnet, daß die Photoresistschicht al lichtempfindliche Verbindung ein 1,2-Naphthochinondiazid enthält.

9. Verfahren zum Entschichten von Photoresistschablonen, dadurch gekennzeichnet, daß man die Schablone durch Behandeln mit einer Lösung einer Verbindung der Formel (I) gemäß Anspruch 1 entschichtet.

**Revendications**

1. Procédé pour le traitement de couches de photoresist par une solution contenant
a) un composé de formule I

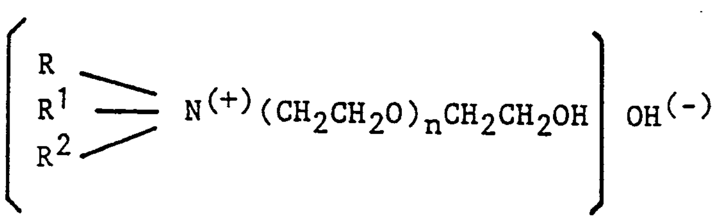

(I)

dans laquelle
R, $R^1$ et $R^2$ sont des groupes alkyle identiques ou différents ayant de 1 à 5 atomes de carbone, et
n est n nombe allanat de 1 à 10;
et
b) de l'eau ou n solvant organique miscible à l'eau, ou un mélange des deux.

2. Procédé selon la revendication 1, caractérisé en ce que la solution ne contient que de l'eau en tant que solvant.

3. Procédé selon la revendication 1, caractérisé en ce que R, $R^1$ et $R^2$ sont des groupes méthyle.

4. Procédé selon la revendication 1, caractérisé en ce que la solution contient de 0,01 à 50% en poids du composé de formule (I).

5. Procédé pour le développement d'une couche de resist photosensible exposée, dans lequel les zones de non image de la couche de photoresist sont éliminées par lavage à l'aide d'unen solution d'une base d'ammonium quaternaire, caractérisé en ce que l'on utilise en tant que base d'ammonium un composé de formule (I) selon la revendication 1.

6. Procédé selon la revendication 5, caractérisé en ce que le composé de formule (I) est dissous dans l'eau ou dans un solvant miscible à l'eau ou dans un mélange des deux.

7. Procédé selon la revendication 6, caractérisé en ce que la couche de photoresist travaillle en positif et les zones exposées de la couche sont éliminées par lavage.

8. Procédé selon la revendication 7, caractérisé en ce que la couche de photoresist contient en tant que composé photosensible un 1,2-naphtoquinonediazide.

9. Procédé pour le déliminage de masques de photoresists, caractérisé en ce que l'on délamine les masques par traitement par une solution d'un composé de formule (I) selon la revendication 1.

**Claims**

1. Process for the treatment of photoresist layers with a solution containing

a) a compound of the formula I

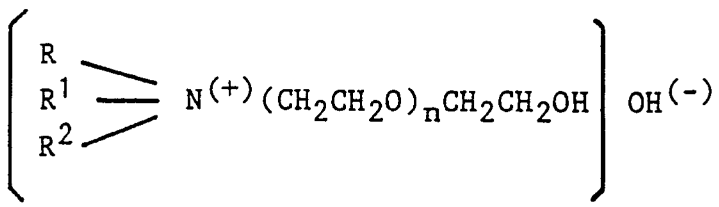

(I)

in which R, $R^1$ and $R^2$ are identical or different alkyl groups having 1 to 5 carbon atoms and

n is a number from 1 to 10, and

b) water of a water-miscible organic solvent or a mixture of both.

2. Process according to Claim 1, characterized in that the solution contains only water as the solvent.

3. Process according to Claim 1, characterized in that R, $R^1$ and $R^2$ are methyl groups.

4. Process according to Claim 1, characterized in that the solution contains 0.01 to 50% by weight of the compound of the formula I.

5. Process for developing an exposed, light-sensitive photoresist layer, in which the non-image areas of the photoresist layer are washed out with a solution of a quaternary ammonium base, characterized in that the ammonium base employed is a compound of the formula I according to Claim 1.

6. Process according to Claim 5, characterized in that the compound of the formula I is dissolved in water or in a water-miscible solvent or in a mixture of both.

7. Process according to Claim 6, characterized in that the photoresist layer operates positively and the exposed areas of layer are washed out.

8. Process according to Claim 7, characterized in that the photoresist layer contains a 1,2-naphthoquinone diazide as the light-sensitive compound.

9. Process for stripping photoresist stencils, characterized in that the stencil is stripped by treatment with a solution of a compound of the formula I according to Claim 1.